# EUROPEAN PATENT APPLICATION

(11) **EP 2 337 103 A1**
(43) Date of publication of application: **22.06.2011**
(21) Application number: 09809850.2
(22) Date of filing: 21.08.2009
(51) Int. Cl.: H01L 41/083, F02M 51/06, H01L 41/187, H01L 41/22, H02N 2/00

(54) **MULTILAYER PIEZOELECTRIC ELEMENT, INJECTION DEVICE USING SAME AND FUEL INJECTION SYSTEM**

(30) Priority: 26.08.2008 JP 2008216188; 16.09.2008 JP 2008236169
(71) Applicant: Kyocera Corporation, Kyoto-shi Kyoto 612-8501 (JP)
(72) Inventor: NAKAMURA,Shigenobu, Kagoshima 899-4396 (JP)
(74) Representative: Beetz & Partner
(86) International application number: PCT/JP2009/064637
(87) International publication number: WO 2010/024199

(57) **Abstract**

Provided is a multi-layer piezoelectric element having excellent durability wherein a conductive member is not peeled off from an external electrode even when the element is continuously driven for a prolonged period of time under high electric field and high pressure. A multi-layer piezoelectric element (1) includes a stacked body (7) wherein piezoelectric layers (3) and internal electrode layers (5) are alternately laminated, and an external electrode (9) which is joined to a side face of the stacked body (7) and electrically connected to the internal electrode layers (5), and the external electrode (9) includes a plurality of open voids (2) in a surface thereof. Due to the open voids (2), a joining strength of a conductive member to the external electrode (9) is improved, thereby preventing peel-off of the conductive member. In addition, since heat dissipation characteristics are improved, it is possible to prevent the external electrode from being thermally fractured due to generation of heat.

## Description

### Technical Field

The present invention relates to a multi-layer piezoelectric element for use, for example, in a driving element (piezoelectric actuator), a sensor element, and a circuit element. Examples of the driving element include a fuel injection device of an automobile engine, a fluid jet device such as an ink jet, a precision positioning device like an optical device, and a vibration prevention device. Examples of the sensor element include a combustion pressure sensor, a knocking sensor, an acceleration sensor, a load sensor, an ultrasonic sensor, a pressure-sensitive sensor, and a yaw rate sensor. Additionally, examples of the circuit element include a piezoelectric gyroscope, a piezoelectric switch, a piezoelectric transformer, and a piezoelectric breaker.

### Background Art

As external electrodes in a conventional multi-layer piezoelectric element, as disclosed in Patent Literature 1, conductive paste including a conductive material such as silver, and glass, is used. This conductive paste is applied to the side faces of the staked body, and is baked to form external electrodes. Also, conductive members for supplying a voltage to the external electrodes are fixedly connected to the outsides of the external electrodes, using solder, a conductive adhesive, or the like.

In the multi-layer piezoelectric element, it is required to secure a large amount of displacement under a high pressure simultaneously with progress of miniaturization. Therefore, it is required that a higher electric field is applied to the multi-layer piezoelectric element, and the multi-layer piezoelectric element can be used under severe conditions of being continuously driven for a prolonged period of time.

### Citation List

### Patent Literature

Patent Literature 1: Japanese Unexamined Patent Publication JP-A 2005-174974

### Disclosure of Invention

### Technical Problem

However, in the multi-layer piezoelectric element using the external electrodes described in Patent Literature 1, there has been a problem that, during use under severe conditions of high voltage, high pressure, prolonged continuous driving and the like, conductive members fixedly connected to the external electrodes are peeled off, and voltage is not supplied to the external electrodes and thus the multi-layer piezoelectric element is not displaced.

Additionally, in a case where a large current is allowed to flow through the external electrodes, thereby driving the multi-layer piezoelectric element at high speed, there has been a problem that the external electrodes generate heat and are thermally fractured.

Otherwise, there has been a problem that portions of the external electrodes may be peeled off from side faces of a stacked body, and supply of voltage to the internal electrode layers of the stacked body may not occur, whereby the multi-layer piezoelectric element cannot maintain an initial displacement.

This is because, when the stacked body expands and contracts in a stacked direction thereof by applying a voltage, stress is generated in joining interfaces between the stacked body and the external electrodes, and this stress exceeds the adhesion force of the external electrodes to the stacked body. That is, in the multi-layer piezoelectric element, in a case where the piezoelectric element is continuously driven for a prolonged period of time with a high voltage, there has been a problem that portions of the external electrodes are peeled off from the side faces of the stacked body due to stress generated in the joining interfaces between the side faces of the stacked body and the external electrodes, and therefore, voltage is no longer supplied to some of the piezoelectric layers via the internal electrode layers from the external electrodes, and thereby displacement characteristics deteriorate.

The invention has been made in view of the above problems, and an object thereof is to provide a multi-layer piezoelectric element in which a conductive member is not peeled off from an external electrode or an external electrode is not thermally fractured, even during use under severe conditions of high voltage, high pressure, prolonged continuous driving and the like.

Additionally, another object of the invention is to provide a multi-layer piezoelectric element capable of improving deterioration of displacement characteristics during use under severe conditions of high voltage, high pressure, prolonged continuous driving and the like.

### Solution to Problem

A first multi-layer piezoelectric element according to the invention comprises a stacked body in which piezoelectric layers and internal electrode layers are alternately laminated; and an external electrode which is joined to a side face of the stacked body and electrically connected to the internal electrode layers, and the external electrode comprises open voids in a surface thereof.

Furthermore, in the above configuration, it is preferable that some of the open voids are located at an edge of the external electrode.

Furthermore, in the above configuration, it is preferable that one of the open voids is formed in a region between adjacent layers of internal electrode layers in a stacked direction thereof.

Furthermore, in the above configuration, it is preferable that some of the plurality of open voids are formed in the region between the adjacent layers of the internal electrode layers in the stacked direction.

Furthermore, in the above respective configurations, it is preferable that a void is located inside the external electrode.

Furthermore, in the above respective configurations, it is preferable that the open voids are formed between metal particles which constitute the external electrode.

Furthermore, in the above respective configurations, it is preferable that the external electrode is jointed to a conductive member.

A second multi-layer piezoelectric element according to the invention comprises a stacked body in which piezoelectric layers and internal electrode layers are alternately laminated; and an external electrode which is joined to a side face of the stacked body and electrically connected to the internal electrode layers, and a plurality of voids are located inside the external electrode with being eccentrically located in a surface side thereof.

Furthermore, in the above configuration, it is preferable that some of the voids are located in a surface layer portion of the external electrode.

Furthermore, in the above respective configurations, it is preferable that a glass component is located inside the external electrode with being eccentrically located in a side of a joining face thereof joining with the stacked body.

Furthermore, in the above configuration, it is preferable that some of the plurality of voids are formed in the region of the external electrode where the glass component is eccentrically located.

Furthermore, in the above respective configurations, it is preferable that the voids are located in a region between adjacent layers of the internal electrode layers in a stacked direction thereof.

Furthermore, in the above respective configurations, it is preferable that the external electrode comprises a glass layer made of the glass component in a surface layer portion on the side of the joining face joining with the stacked body.

Furthermore, in the above configuration, it is preferable that the plurality of voids are located in the glass layer.

Furthermore, in the above configuration, it is preferable that one of the voids is located in a region between adjacent layers of the internal electrode layers in the stacked direction thereof.

An injection device according to the invention comprises a container comprising an injection nozzle; and the multi-layer piezoelectric element according to any one of the inventions mentioned above, and a liquid stored in the container is configured to be injected through the injection nozzle by driving the multi-layer piezoelectric element.

A fuel injection system according to the invention comprises a common rail configured to store high-pressure fuel; the injection device mentioned above configured to inject the high-pressure fuel stored in the common rail; a pressure pump configured to supply the high-pressure fuel to the common rail; and an injection control unit configured to send a driving signal to the injection device.

### Advantageous Effects of Invention

According to the first multi-layer piezoelectric element of the invention, the external electrode comprises a plurality of open voids in the surface thereof. Thus, when a conductive member for supplying a voltage to the external electrode is joined to the external electrode using solder, a conductive adhesive, or the like, the solder or conductive adhesive enters the open voids of the surface of the external electrode. Thereby, the joining of the solder or conductive adhesive to the external electrode becomes favorable, the joining strength of the conductive member is improved, and even in a case where continuous driving is performed under high voltage and high pressure, it is possible to prevent occurrence of the problem that the conductive member is peeled off from the external electrode.

Additionally, since the external electrode comprises the plurality of open voids in the surface thereof, even in a case where a large current is allowed to flow through the external electrode, thereby driving the multi-layer piezoelectric element at high speed, the surface area of the external electrode increases and heat dissipation characteristics are improved. Thus, it is possible to prevent occurrence of the problem that the external electrode is thermally fractured due to generation of heat.

According to the second multi-layer piezoelectric element of the invention, a plurality of voids are located inside the external electrode with being eccentrically located in a surface side thereof. Thus, the plurality of voids which are located the external electrode with being eccentrically located in the surface side thereof can absorb and alleviate stress generated in the external electrode with the deformation accompanying driving of the stacked body. Therefore, it is possible to prevent a portion of the external electrode from being peeled off from the side face of the stacked body or disconnection from being caused inside the external electrode and between the external electrode and the internal electrode layers.

Additionally, since the plurality of voids are located inside the external electrode with being eccentrically located in the surface side thereof, the joining strength on the side of the joining face of the external electrode joining with the stacked body is not reduced. Additionally, even in a case where prolonged continuous driving is performed and cracks are generated in the external electrode from the side face of the stacked body, the voids which are eccentrically located in the surface side operate so as to stop the growth of the cracks. Therefore, it is possible to prevent the external electrode from being disconnected.

According to the injection device of the invention, in a case where the injection device comprises the first multi-layer piezoelectric element of the invention serving as a multi-layer piezoelectric element which injects a liquid stored within a container through an injection nozzle, it is possible to prevent a conductive member of the external electrode from being peeled off from the side face of the stacked body in the multi-layer piezoelectric element and it is possible to prevent occurrence of the problem that the external electrode is thermally fractured due to generation of heat. Thus, desired injection of a liquid can be stably performed for a prolonged period of time.

Additionally, according to the injection device of the invention, in a case where the injection device comprises the second multi-layer piezoelectric element of the invention serving as a multi-layer piezoelectric element configured to inject a liquid stored within a container through an injection nozzle, it is possible to prevent a portion of the external electrode from being peeled off or being disconnected from the side face of the stacked body in the multi-layer piezoelectric element and it is possible to prevent the displacement characteristics of the stacked body from deteriorating. Thus, desired injection of a liquid can be stably performed for a prolonged period of time.

Moreover, according to the fuel injection system of the invention, the fuel injection system includes the injection device of the invention as a device configured to inject the high-pressure fuel stored into the common rail. Thus, desired injection of high-pressure fuel can be stably performed for a prolonged period of time.

### Brief Description of Drawings

Fig. 1 is a perspective view showing an example of a first and a second multi-layer piezoelectric element according an embodiment of the invention;
Fig. 2 is a sectional view of the first and the second multi-layer piezoelectric element of the invention shown in Fig. 1, parallel to a stacked direction thereof;
Fig. 3 is an enlarged sectional view showing an example of a region near a joining interface between a stacked body and an external electrode in the first multi-layer piezoelectric element of the invention shown in Fig. 2;
Fig. 4 is an enlarged side view showing another example of the first multi-layer piezoelectric element according to of the embodiment of the invention;
Fig. 5 is an enlarged side view showing another example of the first multi-layer piezoelectric element according to the embodiment of the invention;
Fig. 6 is an enlarged sectional view showing another example of the first multi-layer piezoelectric element according to the embodiment of the invention;
Fig. 7 is an enlarged sectional view showing another example of the first multi-layer piezoelectric element according to the embodiment of the invention;
Fig. 8 is an enlarged sectional view showing another example of the first multi-layer piezoelectric element according to the embodiment of the invention;
Fig. 9 is a perspective view showing an example in which the conductive member is joined to an outside of the first multi-layer piezoelectric element of the invention;
Fig. 10 is an enlarged sectional view showing an example of a region near a joining interface between a stacked body and an external electrode in the second multi-layer piezoelectric element of the invention shown in Fig. 2;
Fig. 11 is an enlarged sectional view showing another example of the second multi-layer piezoelectric element according to the embodiment of the invention;
Fig. 12 is an enlarged sectional view showing another example of the second multi-layer piezoelectric element according to the embodiment of the invention;
Fig. 13 is an enlarged sectional view showing another example of the second multi-layer piezoelectric element according to the embodiment of the invention;
Fig. 14 is an enlarged sectional view showing another example of the second multi-layer piezoelectric element according to the embodiment of the invention;
Fig. 15 is a schematic sectional view showing an example of an injection device according to an embodiment of the invention; and
Fig. 16 is a schematic view showing an example of a fuel injection system according to an embodiment of the invention.

### Best Mode for Carrying out the Invention

Now referring to the drawings, embodiments of a multi-layer piezoelectric element of the invention and an injection device and a fuel injection system using the same will be described in detail.

### <First embodiment of multi-layer piezoelectric element>

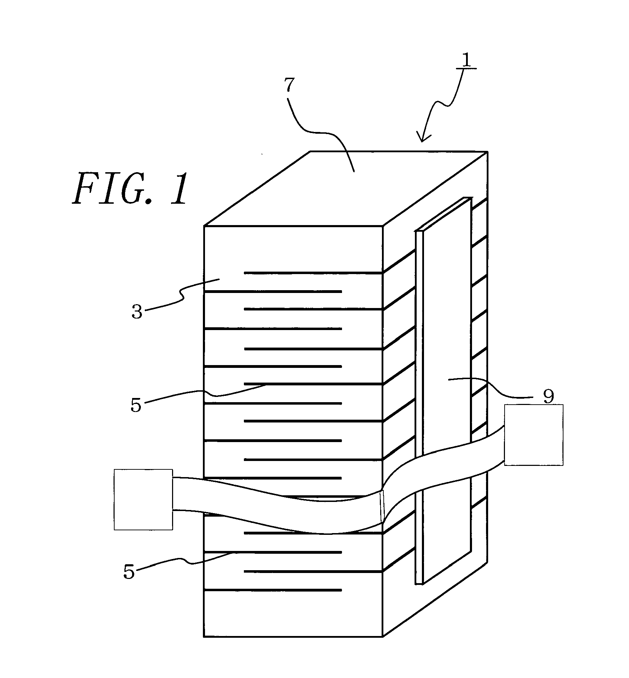

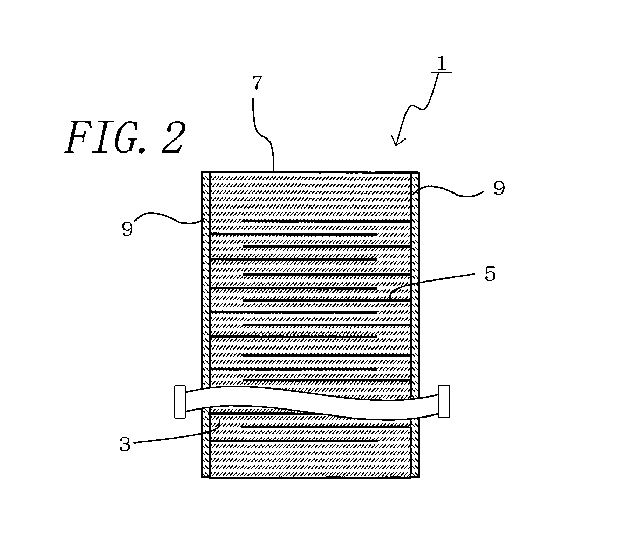

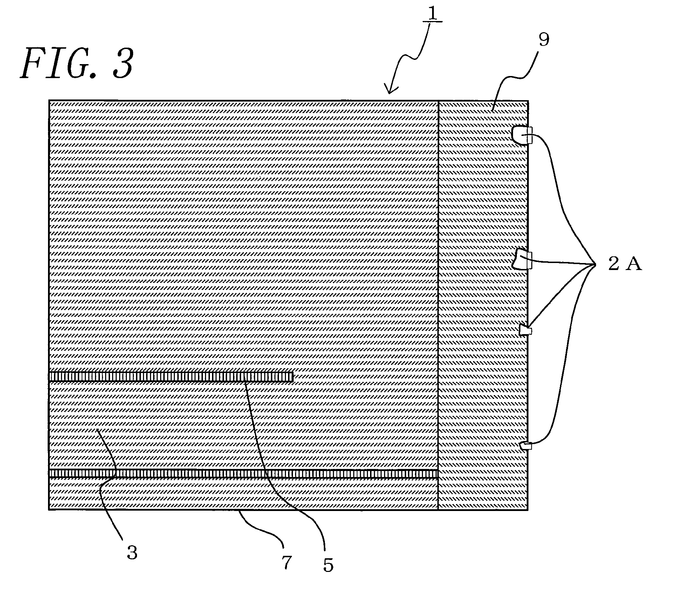

Fig. 1 is a perspective view showing an example of a first multi-layer piezoelectric element according to an embodiment of the invention, and Fig. 2 is a sectional view of the multi-layer piezoelectric element shown in Fig. 1, parallel to a stacked direction thereof. Fig. 3 is an enlarged sectional view showing an example of a region near a joining interface between a stacked body and an external electrode in the multi-layer piezoelectric element shown in Fig. 2.

As shown in Fig. 3, the multi-layer piezoelectric element 1 of the first embodiment comprises a stacked body 7 in which piezoelectric layers 3 and internal electrode layers 5 are alternately laminated, and an external electrode 9 which is joined to a side face of the stacked body 7 and is electrically connected to the internal electrode layers 5, and the external electrode 9 comprises a plurality of open voids 2A in a surface thereof.

By forming the plurality of open voids 2A in the surface of the external electrode 9, in a case where solder or a conductive adhesive is used for the external electrode 9, thereby fixedly connecting a conductive member (not shown) such as a lead wire, the solder or conductive adhesive enters the open voids 2A, and thereby soldering of the solder or conductive adhesive to the external electrode or joining of the conductive adhesive becomes favorable. As a result the joining strength of the conductive member to the external electrode 9 can be markedly improved.

Moreover, since the external electrode 9 comprises the plurality of open voids 2A in the surface thereof, the surface area of the external electrode 9 increases due to the plurality of open voids 2A, and thereby the heat dissipation performance of the external electrode 9 is improved. Thus, even in a case where a large current is allowed to flow through the external electrode 9 so as to drive the multi-layer piezoelectric element 1 at high speed, it is possible to prevent the external electrode 9 from being thermally fractured due to generation of heat of the external electrode 9.

Additionally, although a tensile stress is applied to the external electrode 9 during driving of the multi-layer piezoelectric element 1, the plurality of open voids 2A formed in the surface of the external electrode 9 can be opened or deformed according to the tensile stress applied to the external electrode 9, thereby absorbing the stress. Therefore, even in a case where the multi-layer piezoelectric element 1 is continuously driven at high speed, it is possible to prevent the problem that the external electrode 9 is peeled off from the stacked body 7 from occurring.

The open voids 2A are minute voids which open to the surface of the external electrode 9, and some of the plurality of open voids are located in the surface of the external electrode 9. The shape of the openings of the open voids 2A is not particularly limited, and may be shapes such as a circular shape and an elliptical shape, or may be a polygonal shape, or an irregular shape. Additionally, as for the size of the open voids 2A, when the thickness of the external electrode 9 is, for example, 10 to 50 µm, the size of the openings may be 0.1 to 10 µm in diameter and may be 0.1 to 10 µm in depth. The internal diameter may be almost equal to, greater than, or smaller than the openings.

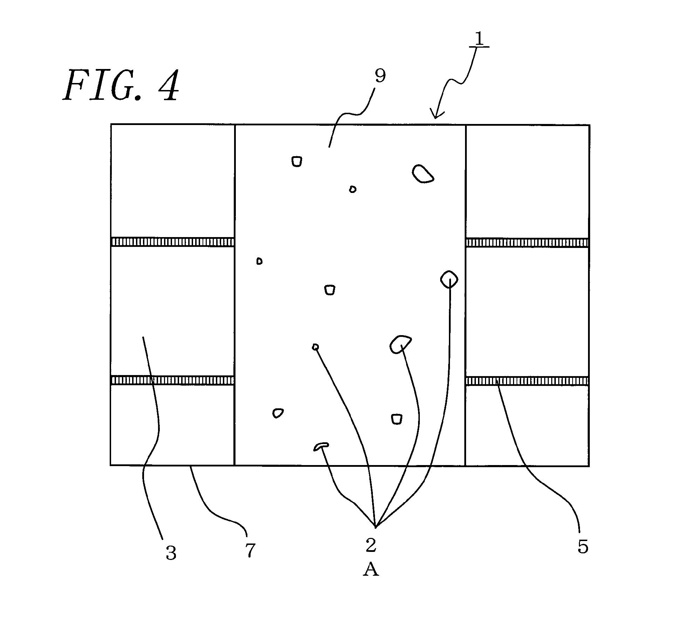

Additionally, as in an enlarged side view of Fig. 4 showing another example of the embodiment of the first multi-layer piezoelectric element 1, it is preferable that the plurality of open voids 2A are almost uniformly and dispersedly formed in the surface of the external electrode 9 since the effect due to the presence of the open voids 2A over the entire external electrode 9 is similarly obtained. In addition, in a case where the effect is locally required, the open voids may be formed so as to be eccentrically located in a desired part.

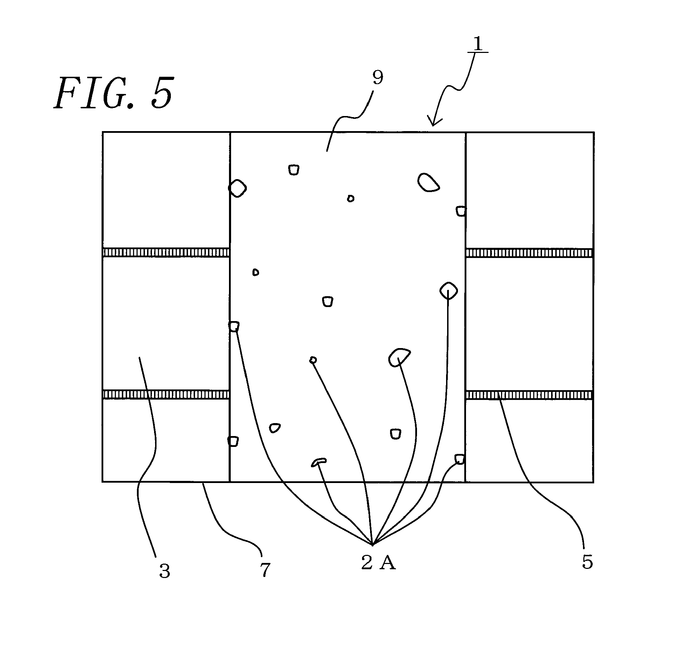

Additionally, as in an enlarged side view of Fig. 5 showing another example of the embodiment of the first multi-layer piezoelectric element 1, it is preferable that the external electrode 9 comprises the open voids 2A in the surface thereof, and some of them are also located at an edge of the external electrode 9. Since it is thereby possible to efficiently radiate heat transmitted from the central portion of the external electrode 9 to the edge thereof, the heat dissipation performance of the external electrode 9 can be further improved.

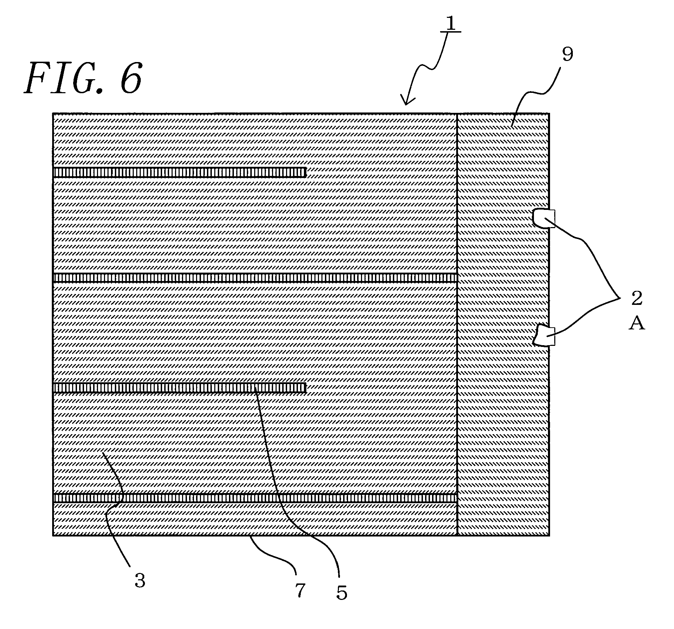

Additionally, as in an enlarged sectional view of Fig. 6 showing another example of the embodiment of the first multi-layer piezoelectric element 1, it is preferable that one of the plurality of open voids 2A is formed in a region between adjacent layers of the internal electrode layers 5 in the stacked direction. Thereby, even in a case where a tensile stress is applied to the conductive member, stress is not applied to joining portions between the internal electrode layers 5 and the external electrode 9 from the parts in which the open voids 2A are formed via solder or a conductive adhesive. Thus, it is possible to prevent the joining portions between the internal electrode layers 5 and the external electrode 9 from being peeled off and disconnected.

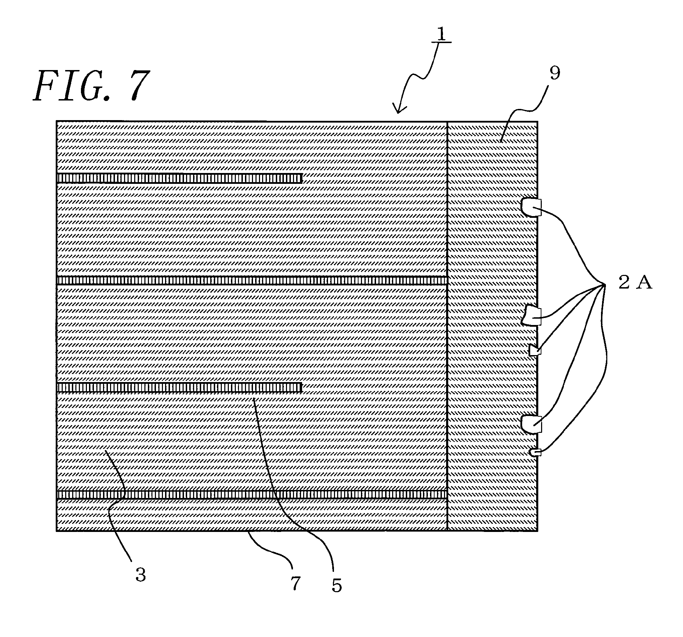

Moreover, as in an enlarged sectional view of Fig. 7 showing another example of the embodiment of the first multi-layer piezoelectric element 1, it is preferable that some of the plurality of open voids 2A are formed in the region between the adjacent layers of the internal electrode layers 5 in the stacked direction. Thereby, the joining strength between the external electrode 9 and the conductive member by solder or a conductive adhesive can be further improved in the regions between the internal electrode layers 5 adjacent to each other in the stacked direction, and the heat dissipation characteristics of the external electrode 9 can be further improved.

Moreover, the effect of alleviating stress generated in the external electrode 9 by expansion and contraction of the stacked body 7 by deformation of the open voids 2A, can be greatly improved by forming some of the plurality of open voids 2A in the region between the adjacent layers of the internal electrode layers 5 in the stacked direction. Additionally, the example in which some of the plurality of open voids 2A are formed in the regions between the adjacent layers of the internal electrode layers 5 in the stacked direction are also shown in Figs. 4 and 5.

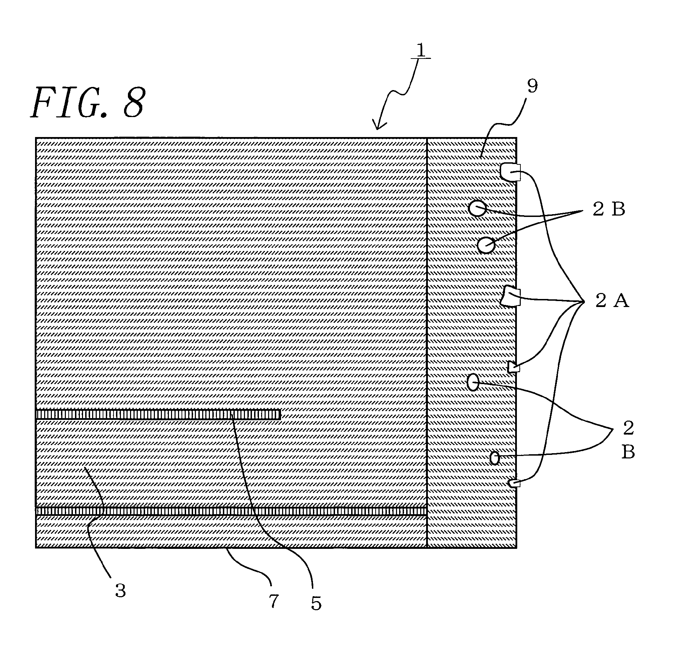

Additionally, in the multi-layer piezoelectric element 1 of the invention, as shown in an enlarged sectional view of Fig. 8 similar to Fig. 3, it is preferable that the external electrode 9 comprises the plurality of open voids 2A in the surface thereof, and voids 2B are located inside the external electrode 9. Thereby, the effect of reducing stress generated in the external electrode 9 by expansion and contraction of the stacked body 7 by the open voids 2A can be further improved by the presence of the voids 2B. This is because stress generated in the external electrode 9 can be absorbed by deformation of the voids 2B according to the stress.

Although the voids 2B are formed similarly to the open voids 2A, the voids do not open to the surface of the external electrode 9, but are located as a closed void inside the external electrode 9. The shape and size of the voids 2B are also not particularly limited, and similarly to the open voids 2A, the cross-sectional shape of the voids may be shapes such as a circular shape and an elliptical shape, or may be a polygonal shape, and an irregular shape. Additionally, the size of the voids 2B may be 0.1 to 10 µm in diameter, for example, when the thickness of the external electrode 9 is 10 to 50 µm.

It is preferable that the voids 2B are almost uniformly and dispersedly formed inside the external electrode 9 since the effect of the presence of the voids 2B over the overall external electrode 9 is similarly obtained. However, in a case where the effect is locally required, the voids may be formed so as to be eccentrically located in required portions if needed.

Additionally, it is preferable that the plurality of open voids 2A are formed between metal particles which constitute the external electrode 9. Since the external electrode 9 is composed of metal particles and a glass component as will be described below, the open voids 2A formed in the surface are formed from the metal particles and the glass component in many cases. However, by forming the open voids 2 between the metal particles, i.e., forming the open voids 2A so as to be surrounded by the metal particles, the inner surfaces of the open voids 2A are formed of a metal having excellent heat dissipation performance. Thus, the heat dissipation performance can be further improved.

In order to form the plurality of open voids 2A between the metal particles in this way, for example, as will be described below, a layer which barely includes a glass component may be arranged on the surface side of the external electrode 9, using two types of paste for forming the external electrode 9 by printing in which metal particles and a glass component are included, and in which only metal particles are included and a glass component are barely included.

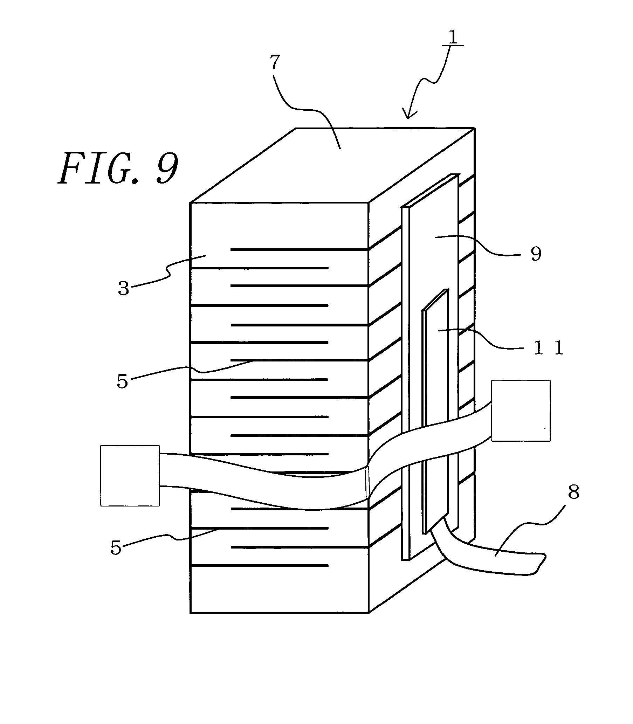

Moreover, in the first multi-layer piezoelectric element 1 according to the invention, as in a perspective view of Fig. 9 showing an example in which the conductive member 8 is joined to the outside of an external electrode, it is preferable that the external electrode 9 is joined to the conductive member 8 such as a lead wire. The conductive member 8 is joined to the external electrode 9 by a bonding material 11 such as solder or a conductive adhesive. In addition, it is preferable that the conductive member 8 is joined over substantially the overall region of the external electrode 9 in the stacked direction by the bonding material 11. By fixedly connecting the conductive member 8 to the external electrode 9 by the bonding material 11 such as solder or a conductive adhesive in this way, a large current can be made to flow through the solder, conductive adhesive, and the conductive member 8. Therefore, even in a case where a large current is allowed to flow so as to drive the multi-layer piezoelectric element 1 at high speed, it is possible to drive the multi-layer piezoelectric element 1 having high durability without local heat generation of the external electrode 9. In addition, as the conductive member 8, a lead wire composed of a metal wire rod, a mesh, or a mesh-like metal plate, and the like can be used.

In addition, the invention is not limited to the examples of the above embodiment, and it is perfectly acceptable that various changes are made without departing from the gist of the invention. For example, the external electrodes 9 are respectively formed on two opposed side faces of the stacked body 7 in the above example.

However, two external electrodes 9 may be formed on adjacent side faces of the stacked body 7, and may be formed on the same side face of the stacked body 7. Additionally, the shape of a cross-section in a direction orthogonal to the stacked direction of the stacked body 7 may be polygonal shapes such as a hexagonal shape and an octagonal shape, a circular shape, or combined shapes of a straight line and a circular arc, other than a quadrangular shape which is the example of the above embodiment.

### <Second embodiment of multi-layer piezoelectric element>

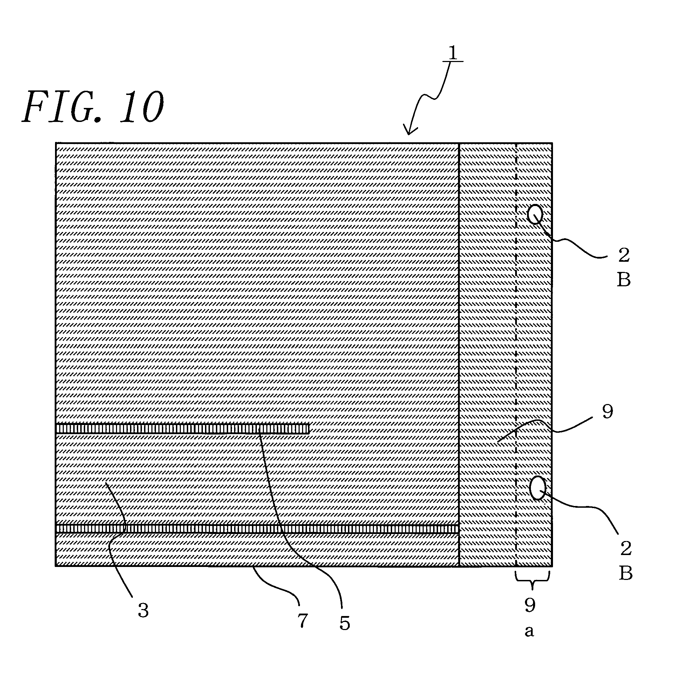

Fig. 1 is a perspective view showing an example of a second multi-layer piezoelectric element according to an embodiment of the invention, and Fig. 2 is a sectional view of the multi-layer piezoelectric element shown in Fig. 1, parallel to the stacked direction thereof. Additionally, Fig. 10 is an enlarged sectional view showing an example of a region near a joining interface between a stacked body and an external electrode in the multi-layer piezoelectric element shown in Fig. 2.

As shown in Fig. 10, the second multi-layer piezoelectric element 1 according to the invention comprises a stacked body 7 in which piezoelectric layers 3 and internal electrode layers 5 are alternately laminated, and an external electrode 9 which is joined to a side face of the stacked body 7 and is electrically connected to the internal electrode layers 5, and a plurality of voids 2B are located inside the external electrode 9 with being eccentrically located in a surface side thereof, i.e., on the opposite side to the stacked body 7.

When the plurality of voids 2B are located inside the external electrode 9 with being eccentrically located in the surface side thereof, i.e., in the inner portion of the external electrode 9 which is apart from the stacked body 7, stress generated in the external electrode 9 when the stacked body 7 has expanded and contracted with the driving of the multi-layer piezoelectric element 1 can be absorbed by deformation of the plurality of voids 2B. As a result, it is possible to prevent occurrence of the problem that a portion of the external electrode 9 is peeled off from the side face of the stacked body 7 due to stress, the external electrode 9 is disconnected within the external electrode 9, or disconnection is made between the external electrode 9 and the internal electrode layers 5.

Additionally, the plurality of voids 2B not only is located in the external electrode 9, but is eccentrically located in the surface side of the external electrode 9. Therefore, in a case where the piezoelectric element is continuously driven for a prolonged period of time, growth of cracks can be suppressed by the voids 2B which are eccentrically located in the surface side of the external electrode 9 even when the cracks are generated from the joining interface of the external electrode 9 with the stacked body 7. Therefore, it is possible to prevent occurrence of the problem that the external electrode 9 is disconnected.

Moreover, since the voids 2B are eccentrically located in the surface side of the external electrode 9 and the heat conductivity on the surface side of the external electrode 9 can be lowered, the temperature distribution of the stacked body 7 joined to the external electrode 9 can be made uniform. That is, in the multi-layer piezoelectric element 1, temperature rises due to self-heating during driving. However, since the external electrode 9 with higher heat conductivity than that of the stacked body 7 is joined to a portion of the side face of the stacked body 7, the portion joined to this external electrode 9 has excellent heat dissipation characteristics. As a result, large temperature distribution occurs in the stacked body 7, thermal stress becomes high, and the stacked body 7 may be damaged. On the other hand, according to the multi-layer piezoelectric element 1 of the invention, since the voids 2B are eccentrically located in the surface side of the external electrode 9, the heat conductivity on the surface side of the external electrode 9 can be lowered. Therefore, it is possible to suppress occurrence of large temperature distribution in the stacked body 7.

The voids 2B are minute closed voids, so-called voids, formed inside the external electrode 9, and are formed inside the external electrode 9 when the external electrode is formed. The shape of the voids 2B is not particularly limited, and may be shapes such as a circular shape and an elliptical shape, or may be a polygonal shape, and an irregular shape. Additionally, the size of the voids 2B may be 0.5 to 10 µm in diameter when the thickness of the external electrode 9 is 10 to 50 µm, for example, in a case where the voids have a spherical shape. When the plurality of such voids 2B are located, stress can be effectively absorbed without having an adverse influence on the resistance or strength of the external electrode 9.

It is preferable that some of the plurality of voids 2B are located in a surface layer portion 9a of the external electrode 9 on the surface side of the external electrode 9. Thereby, since the voids 2B are eccentrically located in the surface layer portion 9a which is the portion of the external electrode 9 to which a maximum stress is applied, stress generated in the external electrode 9 can be effectively reduced.

Here, the surface layer portion 9a of the external electrode 9 is a region to about 2/3 on the surface side of the thickness of the external electrode 9.

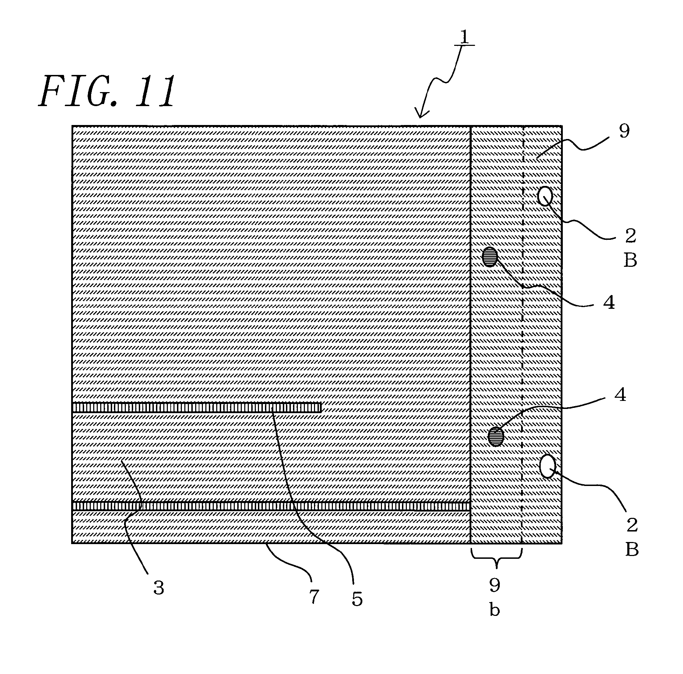

Additionally, in the second multi-layer piezoelectric element 1 according to the invention, as shown in an enlarged sectional view of Fig. 11 similar to Fig. 10, it is preferable that the glass component 4 is located inside the external electrode 9 with being eccentrically located in a side of a joining face thereof joining with the stacked body 7. Since the glass component 4 with a high joining strength with the piezoelectric layers 3 is located inside the external electrode 9 with being eccentrically located in the side of the joining face thereof joining with the stacked body 7, the joining strength of the external electrode 9 to the side face of the stacked body 7 can be improved by increasing the joining strength between the external electrode 9 and the internal electrode layers 5.

The region 9b where the glass component 4 is located inside the external electrode 9 with being eccentrically located in the side of the joining face thereof joining with the stacked body 7 is a region to about 2/3 on the stacked body 7 side of the thickness of the external electrode 9.

Moreover, when the voids 2B is formed in the surface side of the external electrode 9 and the glass component 4 is located inside the external electrode 9 with being eccentrically located in the side of the joining face thereof joining with the stacked body 7, even in a case where a load is applied the multi-layer piezoelectric element 1 in a high electric field during prolonged continuous driving, micro-cracks can be formed in the glass component 4 whose strength is lower than the piezoelectric layers 3, thereby dispersing stress. Moreover, since the plurality of voids 2B which is eccentrically located closer to the surface side than the glass component 4 in the external electrode 9 can prevent growth of micro-cracks formed in the glass component 4, it is possible to manufacture the multi-layer piezoelectric element 1 having high reliability, in which the external electrode 9 does not become fractured.

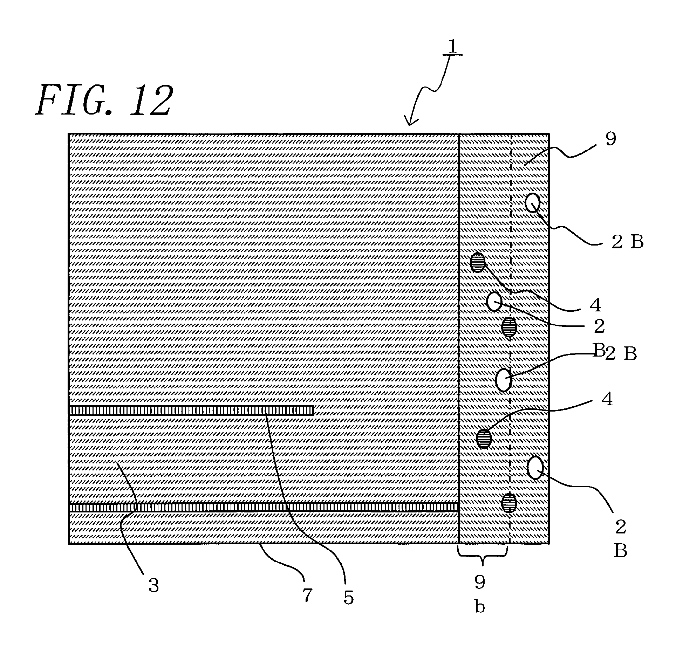

Additionally, in the second multi-layer piezoelectric element 1 according to the invention, as shown in an enlarged sectional view of Fig. 12 similar to Fig. 10, it is preferable that some of the plurality of voids 2B are formed in the region 9b of the external electrode 9 where the glass component 4 is eccentrically located. It is thereby possible to alleviate the stress of the external electrode 9 caused by deformation of the voids 2B in the region 9b where the glass component 4 is eccentrically located, thereby enhancing the effects of peel-off prevention and disconnection prevention of the external electrode 9. Also, it is possible to prevent micro-cracks from growing toward the side of the joining face joining with the stacked body 7 inside the external electrode 9, while obtaining the stress dispersion effect due to the micro-cracks formed in the glass component 4.

Moreover, in the second multi-layer piezoelectric element 1 according to the invention, it is preferable that the plurality of voids 2B are located in a region between adjacent layers of the internal electrode layers 5 in the stacked direction. Thereby, stress generated in the external electrode 9 can be absorbed and alleviated by deformation of the voids 2B which are located in the regions between the adjacent layers of the internal electrode layers 5 in the stacked direction. As a result, it is possible to prevent a load from being applied to the joining portions between the external electrode 9 and the internal electrode layers 5, and it is possible to effectively prevent disconnection from occurring at contact points between the external electrode 9 and the internal electrode layers 5.

Additionally, since it is not enough to exhibit the effects of the void 2B only by forming one void in the external electrode 9, it is necessary to form a plurality of voids on the surface side of the external electrode 9. By forming the plurality of voids 2B in the surface side of the external electrode 9, the stress-reducing effect between the external electrode 9 and the side face of the stacked body 7 can be effectively enhanced. Even in a case where the multi-layer piezoelectric element 1 is continuously driven in a high electric field and at high speed, it is possible to effectively prevent occurrence of the problem that a portion of the external electrode 9 is peeled off from the side face of the stacked body 7 and displacement characteristics deteriorate.

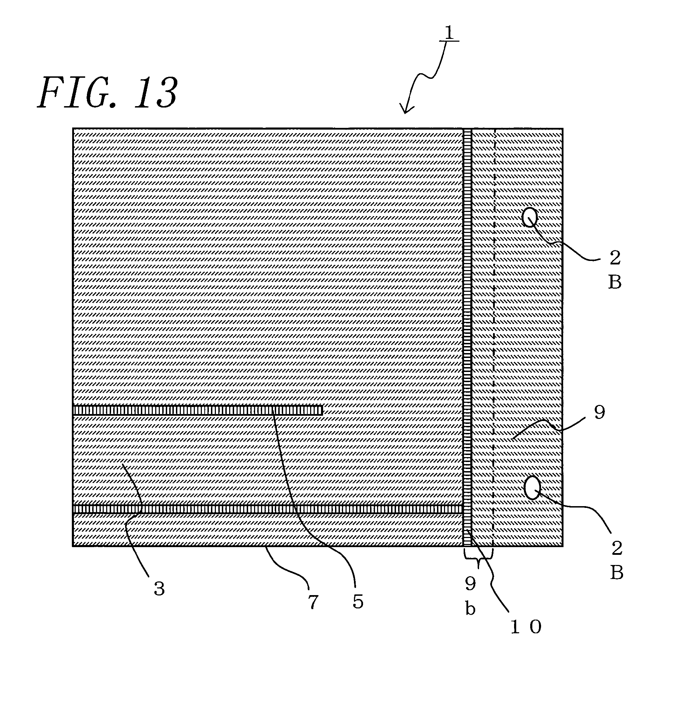

Additionally, in the second multi-layer piezoelectric element 1 according to the invention, as shown in an enlarged sectional view of Fig. 13 similar to Fig. 10, it is preferable that the external electrode 9 comprises the glass layer 10 made of a glass component in the surface layer portion 9b on the side of the joining face joining with the stacked body 7. Fig. 13 is an enlarged sectional view showing an example in which the external electrode 9 comprises the glass layer 10 in the surface layer portion on the side of the joining face joining with the side face of the stacked body 7. That is, by forming the glass layer 10 with a high joining strength with the piezoelectric layers 3 in the surface layer portion 9b on the side of the joining face of the external electrode 9 joining with the stacked body 7, the joining strength of the external electrode 9 to the side face of the stacked body 7 can be made more robust.

The thickness of the glass layer 10 may be within a range of 0.1 to 5 µm, for example, if the thickness of the external electrode 9 is 10 to 50 µm.

In order to form the glass layer 10 made of a glass component in the surface layer portion 9b of the external electrode 9 on the side of the joining face joining with the side face of the stacked body 7 in this way, if the external electrode 9 is formed by printing and baking silver glass conductive paste on the side face of the stacked body 7, the external electrode 9 may be baked at a temperature equal to or higher than the softening temperature of a glass component included in the silver glass conductive paste. Moreover, the silver glass conductive paste which forms the external electrode 9 may be formed and baked with a structure of two or more layers, in order to form the glass layer 10 reliably.

That is, the side faces of the stacked body 7 may be applied and baked with a structure of two or more layers, using silver glass conductive paste with a large content of a glass component for the side of the joining face joining with the side face of the stacked body 7, and using silver glass conductive paste with a small content of a glass component for the side of the opposite face. Thereby, the glass component in the paste softens and flows during baking of the silver glass conductive paste which forms the external electrode 9. However, by using silver glass conductive paste having a large content of the glass component with favorable wettability with the piezoelectric layers 3 for the silver glass conductive paste on the side of the joining face joining with the side face of the stacked body 7, the glass component can be segregated in the external electrode 9 on a side of the side face of the stacked body 7 during baking. As a result, the glass layer 10 can be reliably formed in the surface layer portion 9b on the side of the joining face of the external electrode 9 joining with the side face of the stacked body 7.

As the glass components made to be contained in the silver glass conductive paste in order to form the glass layer 10 on the external electrode 9, silica glass, soda lime glass, lead alkali silicate glass, aluminoborosilicate glass, borosilicate glass, aluminosilicate glass, borate glass, phosphate glass, or the like whose softening temperature is 600 to 950°C, can be used.

Additionally, when the thickness of the glass layer 10 is set to 0.1 to 5 µm, for example, while the thickness of the external electrode 9 is 10 to 50 µm, and is set to about 1/10 of the thickness of the external electrode 9, the joining strength of the external electrode 9 to the side face of the stacked body 7 is increased well, which is preferable.

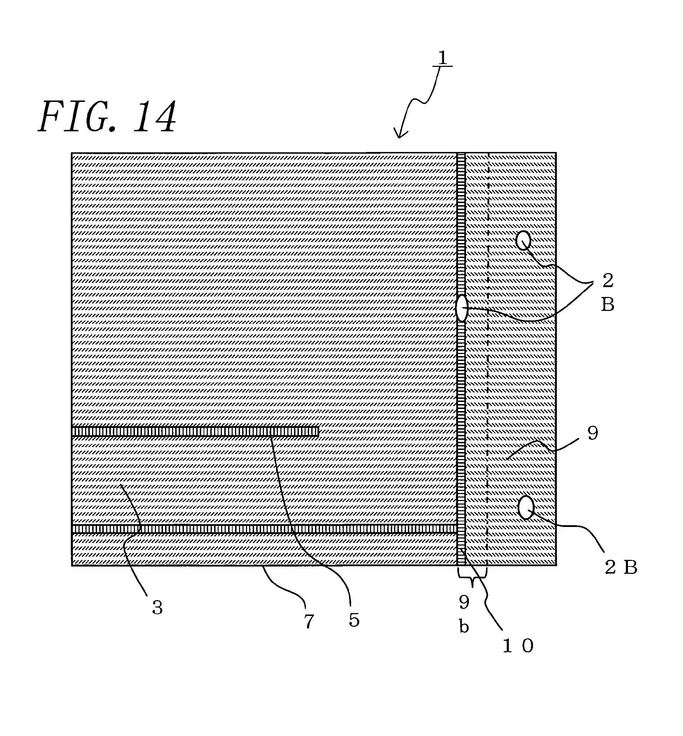

Additionally, in the second multi-layer piezoelectric element 1 according to the invention, as shown in an enlarged sectional view of Fig. 14 similar to Fig. 3, it is preferable that the plurality of voids 2B are located in the glass layer 10. That is, by locating the glass layer 10 which increases the joining strength between the external electrode 9 and the stacked body 7 in the surface layer portion 9b on the side of the joining face joining between the external electrode 9 and the stacked body 7, and locating the voids 2B in the glass layer 10, the voids 2B located in the glass layer 10 can absorb and alleviate stress generated in the joining interface between the external electrode 9 and the stacked body 7 while keeping the joining strength between the external electrode 9 and the stacked body 7 high. Therefore, even in prolonged continuous driving, it is possible to effectively prevent occurrence of the problem that the external electrode 9 is peeled off from the side face of the stacked body 7.

Moreover, in the second multi-layer piezoelectric element 1 according to the invention, it is preferable that one of the plurality of voids 2B located in the glass layer 10 is located in a region between adjacent layers of the internal electrode layers 5 in the stacked direction. Thereby, one of the plurality of voids 2B is located in the glass layer 10 formed in the surface layer portion 9b on the side of the joining face joining with the stacked body 7 which is a portion to which a maximum stress is applied while keeping the conductive connection between the external electrode 9 and the internal electrode layers 5 favorable. Therefore, the stress dispersion effect in the external electrode 9 is further enhanced.

In addition, the invention is not limited to the example of the above embodiment, and it is perfectly acceptable that various changes are made without departing from the gist of the invention. For example, the external electrodes 9 are respectively formed on two opposed side faces of the stacked body 7 in the above embodiment. However, two external electrodes 9 may be formed on adjacent side faces of the stacked body 7, and may be formed on the same side face of the stacked body 7. Additionally, the shape of a cross-section in a direction orthogonal to the stacked direction of the stacked body 7 may be polygonal shapes such as a hexagonal shape and an octagonal shape, a circular shape, or combined shapes of a straight line and a circular arc, other than a quadrangular shape which is the above example.

### <Embodiment of injection device>

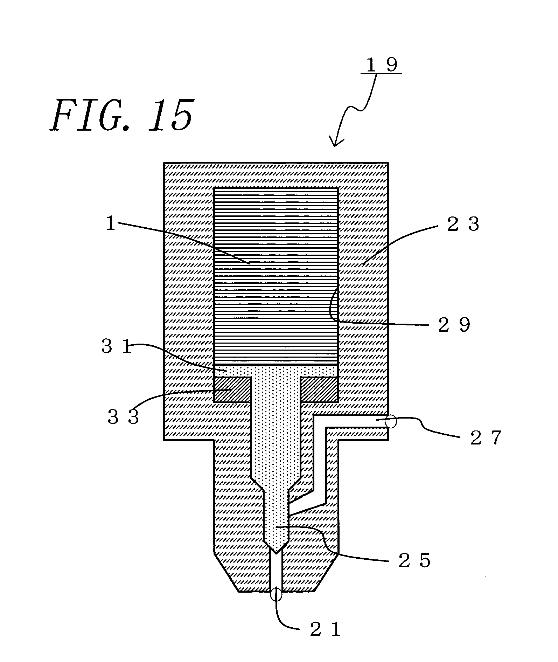

Next, an example of an injection device according to an embodiment of the invention will be described. Fig. 15 is a schematic sectional view showing an example of an injection device according to an embodiment of the invention.

As shown in Fig. 15, the injection device 19 of the present embodiment comprises a housing container (container) 23 having an injection nozzle 21 at one end thereof, and the multi-layer piezoelectric element 1 represented by the example of the above embodiment of the invention, configured to be housed inside the housing container 23.

A needle valve 25 capable of opening and closing the injection nozzle 21 is disposed within the housing container 23. A fluid passage 27 is disposed in the injection nozzle 21 so as to be capable of communicating with the injection nozzle 21 according to the movement of the needle valve 25. The fluid passage 27 is connected to an external fluid supply source from which a fluid is supplied to the fluid passage 27 always at a high pressure. Accordingly, when the needle valve 25 opens the injection nozzle 21, the fuel which has been supplied to the fluid passage 27 is injected to the outside or an adjacent container, for example, a combustion chamber (not shown) of an internal combustion engine, through the injection nozzle 21.

Additionally, the upper end of the needle valve 25 has a larger internal diameter, and has arranged therein a piston 31 slidable on a cylinder 29 formed in the housing container 23. Then, the multi-layer piezoelectric element 1 of the invention as mentioned above is housed in the housing container 23.

In such an injection device 19, when a voltage is applied to the multi-layer piezoelectric element 1, and the multi-layer piezoelectric element expands, the piston 37 is pressed, and the needle valve 25 blocks the fluid passage 27 leading to the injection nozzle 21 to stop the supply of the fluid. Additionally, when the application of a voltage is stopped, the multi-layer piezoelectric element 1 contracts, the dish spring 33 pushes back the piston 31, the fluid passage 27 is opened, and the injection nozzle 21 communicates with the fluid passage 27 so that injection of the fuel is performed through the injection nozzle 21.

In addition, a voltage is applied to the multi-layer piezoelectric element 1, thereby opening the fluid passage 27, and the application of a voltage is stopped, thereby blocking the fluid passage 27.

Additionally, the injection device 19 of the invention includes a container 23 having the injection nozzle 21, and the multi-layer piezoelectric element 1 of the invention, and may be constructed so that a fluid stored in the container is configured to be injected through the injection nozzle 21 by driving the multi-layer piezoelectric element 1. That is, the multi-layer piezoelectric element 1 is not necessarily housed inside the container, and may be constructed so that the pressure for controlling the injection of the fluid is applied to the inside of the container by driving the multi-layer piezoelectric element 1. In addition, in the present invention, various liquid fluids (conductive paste or the like) other than fuel or ink, and gases are included in the fluid. By using the injection device 19 of the invention, the flow rate and injection timing of the fluid can be stably controlled for a prolonged period of time.

When the injection device 19 of the invention which has adopted the multi-layer piezoelectric element 1 of the invention is used for an internal combustion engine, fuel can be injected into a combustion chamber of an internal combustion engine such as an engine, with high precision for a longer period of time compared to a conventional injection device.

### <Embodiment of fuel injection system>

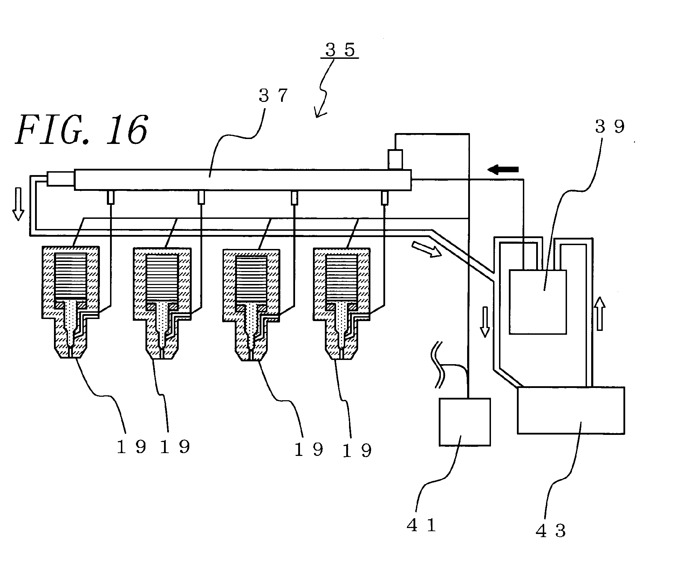

Next, an example of a fuel injection system according to an embodiment of the invention will be described. Fig. 16 is a schematic view showing an example of a fuel injection system according to an embodiment of the invention.

As shown in Fig. 16, the fuel injection system 35 of the present embodiment includes a common rail 37 configured to store high-pressure fuel as a high-pressure fluid, a plurality of the injection devices 19 of the invention configured to inject the high-pressure fluid stored in the common rail 37, a pressure pump 39 configured to supply the high-pressure fluid to the common rail 37, and an injection control unit 41 configured to send a driving signal to the injection device 19.

The injection control unit 41 controls the amount and timing of injection of the high-pressure fluid on the basis of external information or a signal from the outside. For example, in a case where the injection control unit 41 is used for fuel injection of the engine, the amount and timing of fuel injection can be controlled while sensing the situation of the engine combustion chamber by a sensor or the like.

The pressure pump 39 plays the role of supplying fluid fuel to the common rail 37 at high pressure from the fuel tank 43. For example, the fuel injection system 35 of the engine feeds fluid fuel into the common rail 37 at a high pressure of about 1000 to 2000 atmospheres, and preferably about 1500 to 1700 atmospheres. In the common rail 37, the high-pressure fuel sent from the pressure pump 39 is stored and appropriately fed into the injection device 19. The injection device 19 injects a certain amount of fluid to the outside or an adjacent container through the injection nozzle 21 as mentioned above. For example, in a case where an object to which fuel is injected and supplied is an engine, high-pressure fuel is injected in the form of a mist through the injection nozzle 21 to a combustion chamber of the engine.

### <Manufacturing method>

A method of manufacturing the first multi-layer piezoelectric element according to the invention will be described.

First, ceramic green sheets which become the piezoelectric layers 3 are manufactured. Specifically, calcined powder of piezoelectric ceramics, a binder made of an organic polymer such as acrylics or butyrals, and a plasticizer are mixed together to manufacture a slurry. Also, a ceramic green sheet is manufactured from this slurry by using tape casting methods such as a doctor blade method and a calendar roll method. As the piezoelectric ceramics, those having piezoelectric characteristics may be adopted. For example, a perovskite-type oxide made of PbZrO₃-PbTiO₃ or the like can be used. Additionally, DBP (dibutyl phthalate), DOP (dioctyl phthalate), or the like can be used as the plasticizer.

Next, a conductive paste which becomes the internal electrode layers 5 is manufactured. Specifically, the conductive paste can be manufactured by adding and mixing a binder, and a plasticizer to metal powder of silver-palladium. This conductive paste is printed in the pattern of the internal electrode layers 5 on the above ceramic green sheet, using a screen printing method. Moreover, after a plurality of ceramic green sheets on which this conductive paste has been printed is laminated, and the resulting stacked body is subjected to binder removal treatment a predetermined temperature, the stacked body 7 is fired at 900 to 1200°C. Thereby, the stacked body 7 including the piezoelectric layers 3 and the internal electrode layers 5 which are alternately laminated can be formed.

In addition, the stacked body 7 is not limited to one manufactured by the above manufacturing method. As long as the stacked body 7 obtained by alternately laminating a plurality of piezoelectric layers 3 and a plurality of internal electrode layers 5 can be manufactured, the stacked body may be formed by any kinds of manufacturing method.

Next, the stacked body 7 obtained by firing is ground using a surface grinder or the like so as to form a predetermined shape.

Thereafter, the silver glass conductive paste, which has been manufactured by adding a binder, a plasticizer, and a solvent to conductive material powder made mainly of silver, and glass powder, is printed in the pattern of the external electrode 9 on the side face of the stacked body 7 by screen printing or the like. Thereafter, the external electrode 9 can be formed by performing drying and baking at a predetermined temperature.

Here, in order to form the plurality of open voids 2A in the surface of the external electrodes 9, the surface of the external electrode 9 may be blasted by sandblasting of particles, dry ice blasting, or the like after the external electrode 9 is formed by baking. Specifically, the open voids 2A with about 5 µm can be formed in the surface of the external electrode 9 by blasting abrasive particles with a particle size of about 3 µm against the surface of the external electrode 9.

Additionally, as another method, the aforementioned silver glass conductive paste is applied to the side face of the stacked body 7 which forms the external electrode 9. Then, paste for forming voids manufactured by adding a void material and a binder, a plasticizer, and a solvent, which are to be burned out during baking, to a conductive material powder made mainly of silver is printed on the surface of the external electrode 9, and dried at a predetermined temperature, and baked. Thereby, the external electrode 9 including the plurality of open voids 2A in the surface thereof can be formed. In this case, specifically, the aforementioned paste for forming voids is manufactured using a void material made of acrylic beads with an average particle size of 5 µm, and the paste for forming voids is applied and dried with a thickness of about 8 µm to an upper surface on which the silver glass conductive paste has been applied and dried, and then baked at a temperature of 630 to 800°C. Thereby, the acrylic beads are burned out during baking, and the external electrode 9 including the open voids 2A in the surface thereof can be formed.

Here, as the void material used for the paste for forming voids, carbon powder or beads made of organic resin such as acrylic beads, is preferable. The open voids 2A are formed in the surface of the external electrode 9 after baking of the paste for forming voids, in conformity with the shape and the size of the void material.

Moreover, as still another method, first, the aforementioned silver glass conductive paste is printed and dried on the side face of the stacked body 7 which form the external electrode 9, and then is baked at a predetermined temperature. Thereafter, the silver paste manufactured by adding a binder, a plasticizer, and a solvent to a conductive material powder made mainly of silver is printed and dried on the surface of the external electrode, and is baked at a lower temperature than the baking of the silver glass conductive paste. Thereby, the external electrode 9 including the plurality of open voids 2A in the surface thereof can be formed. That is, the external electrode 9 including the plurality of open voids 2A can be formed in the surface by baking the silver paste at a temperature at which sintering of silver does not progress.

Specifically, by baking the silver glass conductive paste at a temperature of 680 to 950°C and baking the silver paste to be printed on the surface of the conductive paste at a temperature of 600 to 680°C, the glass component in the silver glass conductive paste is firmly joined to the side face of the stacked body 7. On the other hand, a plurality of open voids 2A can be formed in the surface of the external electrode 9 by sintering of silver powder in the silver paste.

In addition, in order to form the open voids 2A so as to be eccentrically located on the surface of the external electrode 9 in the regions between the internal electrode layers 5 adjacent to each other in the stacked direction, for example, the open voids 2A can be formed in desired places by performing the aforementioned blasting in a state where the places where the open voids 2A are not to be formed are masked. Additionally, for example, the aforementioned paste for forming voids may be applied and baked to only the places to be formed with the open voids 2A.

Additionally, the external electrode 9 including the voids 2B inside the external electrode 9 can be formed by increasing the thickness of the aforementioned void material paste.

Otherwise, the voids 2B can also be formed inside the external electrode 9 by increasing the thickness of the aforementioned silver paste.

Next, as shown in the perspective view of Fig. 9, the conductive member 8 made of a lead wire composed of a metal wire rod, a metal mesh, or a mesh-like metal plate, and the like is joined and fixedly connected to the surface of the external electrode 9, using the bonding material 11 such as solder or a conductive adhesive.

Here, the material of the conductive member 8 is preferably metals or alloys such as silver, nickel, copper, phosphor bronze, iron, and stainless steel. Additionally, plating of silver, nickel, or the like may be performed on the surface of the conductive member 8.

In addition, the conductive member 8 may be joined to the overall external electrode 9 in the stacked direction, and may be joined to a portion of the external electrode 9.

Next, the stacked body 7 in which the external electrode 9 has been formed is immersed in a resin solution including sheathing resin made of silicone rubber. Then, by vacuum-deaerating the silicone resin solution, the silicone resin is brought into close contact with concavo-convex portions of the outer peripheral side face of the stacked body 7, and thereafter, the stacked body 7 is pulled up from the silicone resin solution. Thereby, the silicone resin is coated on the side face of the stacked body 7 on which the external electrode 9 has been formed.

Thereafter, the multi-layer piezoelectric element 1 of the present embodiment is completed by applying a direct-current electric field of 0.1 to 3 kV/mm to the conductive member 8 connected to the pair of external electrodes 9, and by polarizing the piezoelectric bodies which constitute the stacked body 7. According to this multi-layer piezoelectric element 1, the individual piezoelectric layers 3 can be greatly displaced by an inverse piezoelectric effect by connecting the external electrodes 9 and an external power source via the lead wire which is the conductive member 8, and applying a voltage to the piezoelectric layers 3. Thereby, for example, it is possible to make the multi-layer piezoelectric element function as a fuel injection valve for an automobile which injects and supplies fuel to an engine.

Next, a method of manufacturing the second multi-layer piezoelectric element according to the invention will be described.

Since this method is the same as the method of manufacturing the first multi-layer piezoelectric element according to the invention described above from the step of manufacturing a ceramic green sheet which becomes the piezoelectric layer 3 to the step of printing the silver glass conductive paste, which has been manufactured by adding a binder, a plasticizer, and a solvent to conductive material powder made mainly of silver, and glass powder, in the pattern of the external electrode 9 on the side face of the stacked body 7 by screen printing or the like, and then drying and baking the conductive paste at a predetermined temperature, the description thereof is omitted.

In order to form the voids 2B so as to be eccentrically located on the surface side of the external electrode 9, the silver glass conductive paste which becomes the external electrode 9 after baking is printed on the side face of the stacked body 7 which forms the external electrode 9, and then, the silver conductive paste containing a void material prepared by dispersing the void material in the surface of the conductive paste is printed and baked, and thereby the void material is burned out during baking. Thereby, the plurality of desired voids 2B can be formed so as to be eccentrically located on the surface side of the external electrode 9.

Here, as the void material, carbon powder, or beads made of organic resin such as acrylic beads, is preferable. By adding and mixing conductive material powder made mainly of silver, and a binder to the void material, the silver conductive paste containing a void material can be prepared.

Additionally, in order to eccentrically locate the glass component 4 on the side of the joining face joining between the external electrode 9 and the stacked body 7, the silver glass conductive paste with a large additive amount of glass powder may be printed on the side face of the stacked body 7, and the silver conductive paste containing a void material may be printed and baked on the surface of the conductive paste.

Additionally, in order to form the voids 2B even in the region 9a where the glass components 4 are eccentrically located, a void material may be added even to the silver glass conductive paste to be printed on the side face of the stacked body 7.

Here, the silver conductive paste containing a void material may be printed and baked after the silver glass conductive paste is printed as mentioned above, and the silver conductive paste containing a void material may be printed and baked after the silver glass conductive paste is printed and baked.

Next, the stacked body 7 in which the external electrodes 9 have been formed is immersed in a resin solution (silicone resin solution) for forming sheathing resin including silicone rubber. Then, by vacuum-deaerating the silicone resin solution coated on the surface of the stacked body 7 in which the external electrodes 9 have been formed, the silicone resin solution is brought into close contact with concavo-convex portions of the outer peripheral side face of the stacked body 7, and thereafter, the stacked body 7 is pulled up from the silicone resin solution. Thereby, the sheathing resin including silicone rubber is coated on the side faces of the stacked body 7 on which the external electrodes 9 have been formed. Then, lead wires (not shown) serving as current-carrying parts are connected to the external electrodes 9 with a conductive adhesive or the like.

Thereafter, the multi-layer piezoelectric element 1 of the present embodiment can be obtained by applying a direct-current electric field of 0.1 to 3 kV/mm to the pair of external electrodes 9 formed on the facing side faces of the stacked body 7, and by polarizing the piezoelectric layers 3 which constitute the stacked body 7.

According to this multi-layer piezoelectric element 1, the individual piezoelectric layers 3 can be greatly displaced by an inverse piezoelectric effect by connecting the external electrodes 9 and an external power source via the lead wire, and applying a voltage to the piezoelectric layers 3. Thereby, for example, it is possible to make the multi-layer piezoelectric element function as a fuel injection valve for an automobile which injects and supplies fuel to an engine. When the individual piezoelectric layers 3 are greatly displaced, and the stacked body 7 has expanded and contracted greatly, stress generated in the external electrode 9 can be alleviated by the plurality of voids 2B, and the multi-layer piezoelectric element 1 which can be stably driven for a prolonged period of time is provided.

### Examples

### <Example of first multi-layer piezoelectric element>

A piezoelectric actuator including the multi-layer piezoelectric element of the invention was prepared as follows. First, a slurry was prepared which was obtained by mixing calcined powder of piezoelectric ceramics made mainly of lead zirconate titanate (PbZrO₃-PbTiO₃) with an average particle size of 0.4 µm, a binder, and a plasticizer. A ceramic green sheet which becomes a piezoelectric layer 3 with a thickness of 150 um was prepared using this slurry by a doctor blade method.

Additionally, a binder was added to a silver-palladium alloy, thereby preparing conductive paste which becomes internal electrode layers.

Next, the conductive paste which becomes the internal electrode layers was printed on one side of the ceramic green sheet by a screen printing method, and 300 ceramic green sheets on which the conductive paste was printed were laminated. Then, a stacked body was obtained by performing firing at 980 to 1100°C.

After the obtained stacked body was ground into a predetermined shape using a surface grinder, silver glass conductive paste was applied to side faces of the stacked body which forms an external electrode. Thereafter, acrylic beads with an average particle size of 5 µm were added to silver powder, and a binder, a plasticizer, and a solvent were further added thereto so as to manufacture the paste for forming voids, and then the paste for forming voids was printed with a thickness of 8 µm, and was baked at 650°C.

Additionally, a multi-layer piezoelectric element of Sample No. 1 with no open voids in the surface of an external electrode, not in the scope of the invention, was manufactured as a comparative example. This was obtained by printing and drying the silver glass conductive paste which becomes an external electrode, and then, baking the conductive paste at 950°C.

In addition, in a multi-layer piezoelectric element of Sample No. 2 which is an example of the invention manufactured using the paste for forming voids, a plurality of open voids with an average opening diameter of 4 µm and a depth of 3 µm was formed in the surface of the external electrode. In addition, at this time, the open voids were about 5000 pieces/mm² in the surface of the external electrode, and were substantially uniformly distributed.

Additionally, in a multi-layer piezoelectric element of Sample No. 3 which is an example of the invention in which the paste for forming voids was painted with a thickness of 20 µm, and was baked at 650°C, a plurality of open voids with an average opening diameter of 4 µm and a depth of 3 µm was formed in the surface of the external electrode, and voids with an average diameter of 4 µm were formed inside the external electrode. At this time, the open voids were about 5000 pieces/mm² in the surface of the external electrode, and were substantially uniformly distributed. Additionally, the voids were eccentrically located near the surface of the external electrode.

Moreover, in a multi-layer piezoelectric element of Sample No. 4 which is an example of the invention in which the paste for voids was printed with a thickness of 8 µm even at the edges of the external electrode and was baked at 650°C, the same open voids as those of the multi-layer piezoelectric element of Sample No. 2 were formed in the surface of the external electrode, and the open voids were formed even at the edges of the external electrode. The open voids were about 70 pieces/mm², and were substantially uniformly distributed.

Additionally, in a multi-layer piezoelectric element of Sample No. 5 which is an example of the invention in which the paste for voids was printed with a thickness of 8 µm even only on the regions between the internal electrode layers adjacent to each other in the stacked direction, and was baked at 650°C, the same open voids as those of Sample No. 2 were formed in the regions between the internal electrode layers adjacent to each other in the stacked direction in the surface of the external electrode.

Next, a conductive member made of a metal mesh was joined and fixedly connected to the surface of the external electrode of each multi-layer piezoelectric element with solder.

Thereafter, with respect to each multi-layer piezoelectric element, a direct-current electric field of 3 kV/mm was applied to the external electrodes, respectively, for 15 minutes via the conductive members, thereby performing polarization treatment. A piezoelectric actuator using a multi-layer piezoelectric element was manufactured in this way. When a direct current voltage of 160 V was applied to the obtained piezoelectric actuator, the amount of displacement of 40 µm was obtained in the stacked direction of the stacked body. Moreover, a test was performed in which an alternating voltage of 0 to +160 V was applied to the piezoelectric actuator at a frequency of 150 Hz at room temperature, and the piezoelectric actuator was continuously driven 1x10⁹ times to 1x10¹⁰ times. The obtained results are shown in Table 1.

**Table 1**

| Sample No. | Open void in surface of external electrode | Void inside external electrode | Amount of displacement after continuous driving | |
|---|---|---|---|---|
| | | | After 1x10⁹ times | After 5x10⁹ times |
| *1 | Absent | Absent | Reduced to 1/2 (**) | Not displaced (***) |
| 2 | Present | Absent | No change | No change |
| 3 | Present | Absent | No change | No change |
| 4 | Present | Absent | No change | No change |
| 5 | Present | Present | No change | No change |

| | | | | |
|---|---|---|---|---|
| * Comparative example **: A crack was generated in the external electrode, and a portion of the external electrode was peeled off from the side face of the stacked body. ***: The conductive member was peeled off from the external electrode. | | | | |

As can be seen from the results shown in Table 1, in the piezoelectric actuator of Sample No. 1 which is a comparative example of the invention, no open voids were present in the surface of the external electrode. Therefore, cracks were generated in the external electrode after driving of 1x10⁹ times, a portion of the external electrode was peeled off from the side face of the stacked body, and displacement characteristics deteriorated. Additionally, when driving was continued to 5x10⁹ times, the conductive member fixedly connected to the external electrode with solder was peeled off from the external electrode and not displaced due to the stress during driving.

On the other hand, in the piezoelectric actuators of Sample Nos. 2 to 5 which are examples of the invention, the plurality of open voids was present in the surface of the external electrode. Thus, stress generated in the external electrode during driving could be absorbed by deformation of the open voids. Therefore, the problem did not occur that a portion of the external electrode was peeled off from the side face of the stacked body, and displacement characteristics deteriorated. Moreover, even if driving was continued to 5x10⁹ times, neither peel-off of the external electrode nor peel-off of the conductive member arose, and changes in displacement characteristics were not seen.

Accordingly, according to the multi-layer piezoelectric element of the invention, a portion of solder which fixedly connects the conductive member enter the open voids, and thereby the joining strength is improved. Therefore, it was found that high reliability is secured without occurrence of the problem that the conductive member is peeled off, even in a case where continuous driving is performed in a high electric field. Additionally, since the surface of the external electrode is provided with the plurality of open voids, these open voids contribute to effectively radiating heat of the external electrode. Therefore, the problem that the external electrode was fractured due to the generation of heat did not occur, either.

In addition, since Sample No. 5 including the voids inside the external electrode can effectively absorb stress generated in the external electrode in cooperation with the open voids in the surface by deformation of these voids. Therefore, even a minute crack was not generated in the external electrode.

### <Example of second multi-layer piezoelectric element>

A piezoelectric actuator including the second multi-layer piezoelectric element according to the invention was prepared as follows. First, a slurry was prepared which was obtained by mixing calcined powder of piezoelectric ceramics made mainly of lead titanate zirconate (PbZrO₃-PbTiO₃) with an average particle size of 0.4 µm, a binder, and a plasticizer. A ceramic green sheet which becomes a piezoelectric layer 3 with a thickness of 150 µm was prepared using this slurry by a doctor blade method.

Additionally, a binder was added to a silver-palladium alloy, thereby preparing conductive paste which becomes internal electrode layers.

Next, the conductive paste which becomes the internal electrode layers was printed on one side of the ceramic green sheet by a screen printing method, and 300 ceramic green sheets on which the conductive paste was printed were laminated. Then, a stacked body was obtained by performing baking at 980 to 1100°C. Next, the obtained stacked body was ground into a predetermined shape using a surface grinder.

Thereafter, there were prepared: silver paste containing a void material prepared by adding a binder and a plasticizer to spherical acrylic beads (average particle size of 5 µm) serving as a void material, and silver powder; silver glass conductive paste containing a void material prepared by adding a binder and a plasticizer to a void material, silver powder, and glass powder (softening temperature of 730°C); and silver glass conductive paste prepared by adding a binder and a plasticizer to silver powder and glass powder (softening temperature of 730°C).

Then, a multi-layer piezoelectric element was prepared by printing any one of the above pastes or a plurality of pastes on the side face of the stacked body which becomes a forming face of the external electrode, and baking the paste(s) at 700°C.

Here, in Sample No. 11 of the comparative example of the invention in which the external electrode was prepared using only the silver glass conductive paste, no voids were not seen in the external electrode.

On the other hand, in Sample No. 12 in which the silver glass conductive paste was printed on the side face of the stacked body, and the silver paste containing a void material was printed and baked on the surface of the conductive paste, substantially spherical voids (average diameter of 3 µm) were formed on the surface side of the external electrode, and a glass component was eccentrically located in the side of the joining face joining with the stacked body.

Additionally, in Sample No. 13 in which the silver glass conductive paste, the silver glass conductive paste containing a void material, and the silver paste containing a void material were printed and baked in the order named on the side face of the stacked body, a region where the voids were formed, a region where the voids and the glass component were present together, and a region where the glass component was eccentrically located were formed toward the joining face joining with the stacked body from the surface side of the external electrode.

Additionally, in Sample No. 14 prepared by the same manufacturing method as Sample No. 11 except that the softening temperature of the glass included in the silver glass conductive paste was set to 600°C, and baking was performed at 700°C, a glass layer with an average thickness of 1 µm was formed on the joining interface between the external electrode and the stacked body, and voids were formed on the surface side of the external electrode.

Thereafter, with respect to each multi-layer piezoelectric element, lead wires were connected to the external electrodes, and a direct-current electric field of 3 kV/mm was applied to the positive and negative external electrodes, respectively, for 15 minutes via the lead wires, thereby performing polarization treatment. A piezoelectric actuator using a multi-layer piezoelectric element was prepared in this way. When a direct current voltage of 160 V was applied to the obtained piezoelectric actuator, the amount of displacement of 40 µm was obtained in the stacked direction of the stacked body. Moreover, a test was performed in which an alternating voltage of 0 to +160 V was applied to the piezoelectric actuator at a frequency of 150 Hz at room temperature, and the piezoelectric actuator was continuously driven 1x10⁹ times to 1x10¹⁰ times. The obtained results are shown in Table 2.

**Table 2**

| Sample No. | Void in surface side of external electrode | Eccentric location of glass component in side of joining face of external electrode joining with stacked body | Presence of void in region of external electrode where glass component is eccentrically located | Glass layer in surface layer portion on side of joining face of external electrode joining with stacked body | Amount of displacement after continuous driving | |
|---|---|---|---|---|---|---|
| | | | | | After 1x10⁹ times | After 5x10⁹ times |
| *11 | Absent | Present | Absent | Absent | Reduced to 1/2 | Not displaced |
| 12 | Present | Present | Absent | Absent | No change | Reduced to 6/7 |
| 13 | Present | Present | Present | Absent | No change | No change |
| 14 | Present | Present | Present | Present | No change | No change |

As can be seen from the results shown in Table 2, in the piezoelectric actuator of Sample No. 11 which is a comparative example of the invention, a plurality of voids which was located inside the external electrode with being eccentrically located in the surface side thereof was not formed. Therefore, stress generated in the external electrode by expansion and contraction of the stacked body during driving could not be absorbed, a portion of the external electrode was peeled off from the side face of the stacked body after driving of 1x10⁹ times, and displacement characteristics deteriorated to 1/2. On the other hand, in the piezoelectric actuators of Sample Nos. 12 to 14 which are examples of the invention, the plurality of voids was located inside the external electrode with being eccentrically located in the surface side thereof. Thus, stress generated during driving could be absorbed by deformation of the voids. Therefore, the problem did not occur that a portion of the external electrode was peeled off from the side face of the stacked body after driving of 1x10⁹ times, and displacement characteristics deteriorated.

Moreover, in Sample No. 13 in which the voids were formed in the region where the glass components were located inside the external electrode with being eccentrically located in the side of the joining face thereof joining with the stacked body, and Sample No. 14 in which the external electrode comprised the glass layer in the surface layer portion on the side of the joining face joining with the stacked body, it was found that a portion of the external electrode was not peeled off from the side face of the stacked body, displacement characteristics did not deteriorate after driving of 1x10¹⁰ times, and high durability was provided.

Reference Signs List
- 1:: Multi-layer piezoelectric element
- 2A:: Open void
- 2B:: Void
- 3:: Piezoelectric layer
- 5:: Internal electrode layer
- 7:: Stacked body
- 8:: Conductive member
- 9:: External electrode
- 10:: Glass layer
- 11:: Bonding material
- 19:: Injection device
- 21:: Injection nozzle
- 23:: Housing container (Container)
- 25:: Needle valve
- 27:: Fluid passage
- 29:: Cylinder
- 31:: Piston
- 33:: Dish spring
- 35:: Fuel injection system
- 37:: Common rail
- 39:: Pressure pump
- 41:: Injection control unit
- 43:: Fuel tank

## Claims

1. A multi-layer piezoelectric element, comprising:
a stacked body in which piezoelectric layers and internal electrode layers are alternately laminated; and
an external electrode which is joined to a side face of the stacked body and electrically connected to the internal electrode layers, wherein
the external electrode comprises a plurality of open voids in a surface thereof.

2. The multi-layer piezoelectric element according to claim 1, wherein some of the plurality of open voids are located at an edge of the external electrode.

3. The multi-layer piezoelectric element according to claim 1 or 2, wherein one of the plurality of open voids is formed in a region between adjacent layers of the internal electrode layers in a stacked direction thereof.

4. The multi-layer piezoelectric element according to claim 3, wherein some of the plurality of open voids are formed in the region between the adjacent layers of the internal electrode layers in the stacked direction.

5. The multi-layer piezoelectric element according to any one of claims 1 to 4, wherein a void is located inside the external electrode.

6. The multi-layer piezoelectric element according to any one of claims 1 to 5, wherein the plurality of open voids are formed between metal particles which constitute the external electrode.

7. The multi-layer piezoelectric element according to any one of claims 1 to 6, wherein the external electrode is joined to a conductive member.

8. A multi-layer piezoelectric element, comprising:
a stacked body in which piezoelectric layers and internal electrode layers are alternately laminated; and
an external electrode which is joined to a side face of the stacked body and electrically connected to the internal electrode layers, wherein
a plurality of voids are located inside the external electrode with being eccentrically located in a surface side thereof.

9. The multi-layer piezoelectric element according to claim 8, wherein some of the plurality of voids are located in a surface layer portion of the external electrode.

10. The multi-layer piezoelectric element according to claim 8 or 9, wherein a glass component is located inside the external electrode with being eccentrically located in a side of a joining face thereof joining with the stacked body.

11. The multi-layer piezoelectric element according to claim 10, wherein some of the plurality of voids are formed in the region of the external electrode where the glass component is eccentrically located.

12. The multi-layer piezoelectric element according to any one of claims 8 to 11, wherein the plurality of voids are located in a region between adjacent layers of the internal electrode layers in a stacked direction thereof.

13. The multi-layer piezoelectric element according to any one of claims 8 to 12, wherein the external electrode comprises a glass layer made of the glass component in a surface layer portion on the side of the joining face joining with the stacked body.

14. The multi-layer piezoelectric element according to claim 13, wherein the plurality of voids are located in the glass layer.

15. The multi-layer piezoelectric element according to claim 14, wherein one of the plurality of voids is located in a region between adjacent layers of the internal electrode layers in a stacked direction thereof.

16. An injection device, comprising:
a container comprising an injection nozzle; and
the multi-layer piezoelectric element according to any one of claims 1 to 15, wherein
a liquid stored in the container is configured to be injected through the injection nozzle by driving the multi-layer piezoelectric element.

17. A fuel injection system, comprising:
a common rail configured to store high-pressure fuel;
the injection device according to claim 16 configured to inject the high-pressure fuel stored in the common rail;
a pressure pump configured to supply the high-pressure fuel to the common rail; and
an injection control unit configured to send a driving signal to the injection device.
